# EUROPEAN PATENT APPLICATION

(11) **EP 2 254 206 A1**
(43) Date of publication of application: **24.11.2010**
(21) Application number: 08722198.2
(22) Date of filing: 14.03.2008
(51) Int. Cl.: H01S 5/022

(54) **OPTICAL MODULE**

(71) Applicant: Mitsubishi Electric Corporation, Tokyo 100-8310 (JP)
(72) Inventor: FUKUDA, Keiichi, Tokyo 100-8310 (JP); TAMAYA, Motoaki, Tokyo 100-8310 (JP); OE, Shinichi, Tokyo 100-8310 (JP); HAMAGUCHI, Tsuneo, Tokyo 100-8310 (JP); NAKAMURA, Akira, Tokyo 100-8310 (JP)
(74) Representative: Zech, Stefan Markus
(86) International application number: PCT/JP2008/054802
(87) International publication number: WO 2009/113180

(57) **Abstract**

To constitute an optical module (50) in which a comb-shaped submount (20) is fixed on a heat sink (1) and a device (30) having an optical functioning unit is mounted on the comb-shaped submount (20), a stress buffering block (10) that relaxes a thermal stress acting between the heat sink and the comb-shaped submount is placed between the heat sink and the comb-shaped submount (20). With this configuration, a thermal stress acting between the comb-shaped submount (20) and the device (30) mounted thereon is relaxed, and as a result, long-term reliability of bonding parts between the comb-shaped submount (20) and the device (30) is enhanced.

## Description

### TECHNICAL FIELD

The present invention relates to an optical module.

### BACKGROUND ART

In an optical module including a device such as a laser device having an optical functioning unit, for which it is desired to control its operating temperature, the device is mounted on a heat sink in many cases. In this case, to relax a thermal stress acting on the device due to a difference in coefficient of linear expansion between the device and the heat sink, a submount made of a material having an approximately identical coefficient of linear expansion as that of the device is placed between the device and the heat sink, and the device is mounted on the submount.

When the device includes only one optical functioning unit such as a light-emitting unit, a light-receiving unit, and a laser oscillating unit, a flat plate-like submount is usually used. Furthermore, when the device is an array-type device including a plurality of optical functioning units, a submount (a support) whose device-mounting surface is formed into a comb-shape as in a diode laser device described in Patent Document 1, for example, is used in some cases so as to prevent a state that heat generated in one of the optical functioning units is transmitted to other units through the submount and a so-called thermal cross-talk that adversely affects characteristics of the optical functioning units occurs.
Patent Document 1: Japanese Patent Application Laid-open No. H11-346031

### DISCLOSURE OF INVENTION

### PROBLEM TO BE SOLVED BY THE INVENTION

When an optical module is formed using a submount whose device-mounting surface is formed into a comb-shape (hereinafter, "comb-shaped submount"), although the device and the comb-shaped submount are bonded to each other in a surface-to-surface relation through plural parts thereof, a bonding area of each bonding part becomes relatively narrow. Therefore, when the optical module is repeatedly exposed to a heat cycle, some bonding parts between the comb-shaped submount and the device are peeled off due to the thermal stress acting therebetween, and it sometimes becomes impossible to prevent thermal cross-talk between optical functioning units.

The present invention has been achieved in view of the above problems, and an object of the present invention is to obtain an optical module having a device mounted on a comb-shaped submount and capable of easily enhancing long-term reliability of bonding parts between the device and the comb-shaped submount.

### MEANS FOR SOLVING PROBLEM

In order to solve the afore-mentioned problems, an optical module according to one aspect of the present invention is constructed in such a manner that a comb-shaped submount is fixed on a heat sink, and a device having an optical functioning unit is mounted on the comb-shaped submount, wherein a stress buffering block that relaxes a thermal stress acting between the heat sink and the comb-shaped submount is placed between the heat sink and the comb-shaped submount.

### EFFECT OF THE INVENTION

According to the optical module of the present invention, the stress buffering block that relaxes a thermal stress acting between the heat sink and the comb-shaped submount is placed. Therefore, as compared with a case that the stress buffering block is not placed, a thermal stress acting between the comb-shaped submount and the device mounted on the comb-shaped submount is relaxed. Therefore, even when the optical module is repeatedly exposed to a heat cycle, a possibility such that bonding parts between the comb-shaped submount and the device are peeled off can be suppressed. As a result, it becomes easy to enhance long-term reliability of bonding parts between the comb-shaped submount and the device.

### BRIEF DESCRIPTION OF DRAWINGS

[FIG. 1] FIG. 1 is a schematic exploded perspective view of an example of an optical module according to the present invention.
[FIG. 2A] FIG. 2A is a schematic diagram of a process of manufacturing the optical module shown in FIG. 1.
[FIG. 2B] FIG. 2B is a schematic diagram of another process of manufacturing the optical module shown in FIG. 1.
[FIG. 3] FIG. 3 is a schematic front view of an example of an optical module having a stress buffering block of a laminated structure, among optical modules according to the present invention.
[FIG. 4] FIG. 4 is a schematic front view of another example of an optical module having a stress buffering block of a laminated structure, among optical modules according to the present invention.
[FIG. 5] FIG. 5 is a schematic front view of an example of an optical module in which grooves are formed in a stress buffering block, among optical modules according to the present invention.
[FIG. 6] FIG. 6 is a schematic front view of another example of an optical module in which grooves are formed in a stress buffering block, among optical modules according to the present invention.
[FIG. 7] FIG. 7 is a schematic front view of still another example of an optical module in which grooves are formed in a stress buffering block, among optical modules according to the present invention.
[FIG. 8] FIG. 8 is a schematic front view of an example of an optical module in which a light-emitting device having a waveguide-type laser oscillating unit is mounted on a comb-shaped submount, among optical modules according to the present invention.

### EXPLANATIONS OF LETTERS OR NUMERALS

- 1: Heat sink
- 10, 10A to 10E: Stress buffering block
- 10a₁, 10b₁: First sub-block
- 10a₂, 10b₂: Second sub-block
- 11: Bonding material having higher elastic modulus than that of soldering material
- 10c, 10d, 10e: Groove
- 20: Comb-shaped submount
- 30, 30F: Device
- 30a, 30b: Optical functioning unit
- 50, 50A to 50F: Optical module

### BEST MODE(S) FOR CARRYING OUT THE INVENTION

Exemplary embodiments of an optical module according to the present invention will be explained below in detail with reference to the accompanying drawings. The present invention is not limited to the embodiments.

### First embodiment.

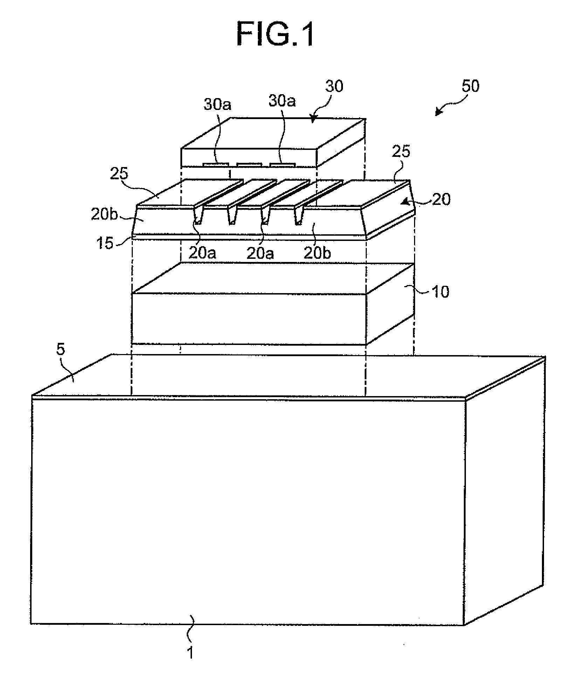

FIG. 1 is a schematic exploded perspective view of an example of the optical module according to the present invention. An optical module 50 shown in FIG. 1 includes a heat sink 1, a stress buffering block 10, a comb-shaped submount 20, and a device 30. The heat sink 1 is a flat plate-like member made of a metallic material or an alloy material having a high thermal conductivity such as copper (Cu). The heat sink 1 has a size of 2.0 mm (length)×10.0 mm (width) as viewed from above, and has a thickness (height) of 5.0 millimeters. A bonding material layer 5 made of a soldering material such as alloy of gold and tin (Au-Sn alloy) is formed on an upper surface of the heat sink 1 by a method such as plating.

The stress buffering block 10 is a rectangular parallelepiped member made of a metallic material or an alloy material having an excellent thermal conductivity such as copper tungsten (CuW) having a coefficient of linear expansion smaller than that of the heat sink 1 and larger than that of the comb-shaped submount 20. The stress buffering block 10 has a size of 1.5 mm (length)x6.0 mm (width) as viewed from above, and has a thickness (height) of 0.8 millimeter. The stress buffering block 10 is formed by only one member and is fixed on the heat sink 1 by the bonding material layer 5.

When the heat sink 1 is made of copper (Cu) having a coefficient of linear expansion of 17×10⁻⁶/°C and the comb-shaped submount 20 is made of aluminum nitride (AlN) having a coefficient of linear expansion of 4.4×10⁻⁶/°C, the stress buffering block 10 can be made of copper tungsten (CuW) having a coefficient of linear expansion of 6.5×10⁻⁶/°C, more specifically, alloy of copper and tungsten (hereinafter, "CuW-10") having 10% copper (Cu) by mass.

The comb-shaped submount 20 is made of a material having an excellent thermal conductivity such as glass and ceramic (such as aluminum nitride), and the comb-shaped submount 20 includes a plurality of bonding parts that are mutually separated from each other by at least one groove formed on a surface of the comb-shaped submount 20 on a side where the device is mounted. Four grooves 20a, 20a, ... are formed on the comb-shaped submount 20 shown in FIG. 1 on a side where the device is mounted, and five bonding parts 20b, 20b, ... in total are formed on the comb-shaped submount 20 on a side where the device is mounted. The comb-shaped submount 20 has a size of 1.5 mm (length)x6.0 mm (width) as viewed from above, and has a thickness (height) of 0.8 millimeter. The comb-shaped submount 20 is fixed on the stress buffering block 10 by a bonding material layer 15 made of a soldering material such as alloy of gold and tin formed on a lower surface of the comb-shaped submount 20.

The device 30 is an array-type device having three optical functioning units 30a placed side-by-side, and each of the optical functioning units 30a functions as a semiconductor laser oscillator. When the device 30 is a semiconductor laser array using an indium phosphide (InP) board, the device 30 has a size of 1.5 mm (length)x2.0 mm (width) as viewed from above, and has a thickness (height) of 0.2 millimeter, and a coefficient of linear expansion thereof is about 4.5×10⁻⁶/°C. The device 30 is fixed and mounted on the comb-shaped submount 20 by a bonding material layer 25 made of a soldering material such as alloy of gold and tin formed on an upper surface of each of the bonding parts 20b of the comb-shaped submount 20. The optical functioning units 30a of the device 30 are individually located on mutually different bonding parts 20b of the comb-shaped submount 20.

In the optical module 50 having the configuration described above, the stress buffering block 10 is placed between the heat sink 1 and the comb-shaped submount 20. A coefficient of linear expansion of the stress buffering block 10 is smaller than that of the heat sink 1 and larger than that of the comb-shaped submount 20. Therefore, as compared with a case that the stress buffering block 10 is not placed, a thermal stress acting between the heat sink 1 and the comb-shaped submount 20 is relaxed, and thus the thermal stress acting between the comb-shaped submount 20 and the device 30 is also relaxed.

Accordingly, even when the optical module 50 is repeatedly exposed to a heat cycle, the bonding parts between the comb-shaped submount 20 and the device 30 are less likely to peel off. As a result, long-term reliability of the bonding parts between the comb-shaped submount 20 and the device 30 is enhanced. The optical module 50 having such a technical effect can be obtained by sequentially fixing the stress buffering block 10, the comb-shaped submount 20 and the device 30 on the heat sink 1.

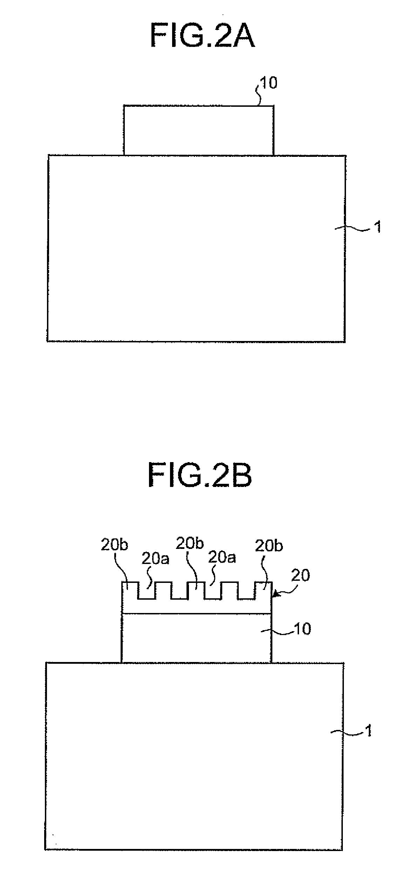

FIGS. 2A and 2B are schematic diagrams of a process of manufacturing the optical module shown in FIG. 1. When manufacturing the optical module 50 shown in FIG. 1, the stress buffering block 10 is first placed on the heat sink 1 on which the bonding material layer 5 (see FIG. 1) is formed as shown in FIG. 2A. The bonding material layer 5 is heated and melted while applying a load to the stress buffering block 10 as needed, and the bonding material layer 5 is then cooled. With this process, the stress buffering block 10 is fixed on the heat sink 1.

Next, as shown in FIG. 2B, the comb-shaped submount 20 is placed on the stress buffering block 10, the bonding material layer 15 (see FIG. 1) is heated and melted while applying a load to the comb-shaped submount 20 as needed, and the bonding material layer 15 is then cooled. With this process, the comb-shaped submount 20 is fixed on the stress buffering block 10.

Thereafter, the device 30 is placed on the comb-shaped submount 20, the bonding material layer 25 (see FIG. 1) is heated and melted while applying a load on the device 30 as needed, and the bonding material layer 25 is then cooled. With this process, the device 30 is fixed and mounted on the comb-shaped submount 20, thereby obtaining the optical module 50.

### Second embodiment.

In the optical module according to the present invention, the structure of the stress buffering block can be a laminated structure in which a plurality of sub-blocks are laminated. When the sub-blocks are bonded to each other by an inorganic bonding material such as a soldering material, a thermal stress acting between the comb-shaped submount and the device is relaxed. From this viewpoint, it is preferable to select the material of the sub-blocks such that a sub-block closer to the comb-shaped submount has a smaller coefficient of linear expansion, and a sub-block closer to the heat sink has a larger coefficient of linear expansion. At this time, a coefficient of linear expansion of a sub-block bonded to the heat sink is equal to or smaller than that of the heat sink, and a coefficient of linear expansion of a sub-block bonded to the comb-shaped submount is equal to or larger than that of the comb-shaped submount.

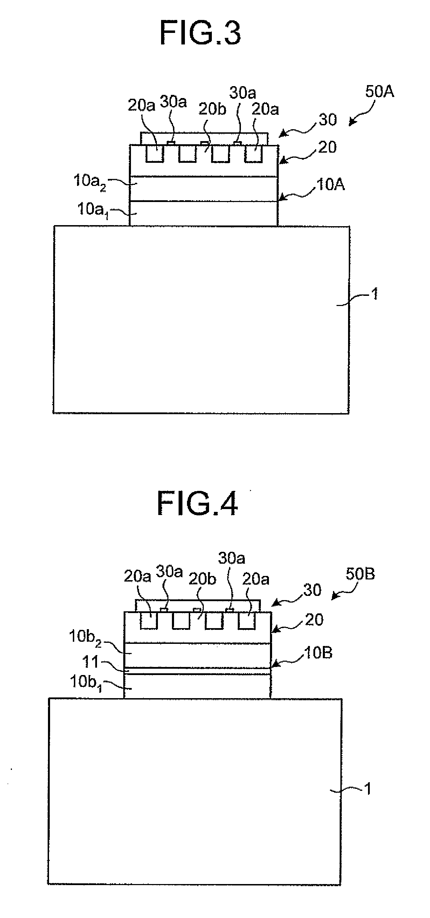

FIG. 3 is a schematic front view of an example of an optical module having a stress buffering block of a laminated structure. An optical module 50A shown in FIG. 3 has the same configuration as that of the optical module 50 shown in FIG. 1, except that the optical module 50A includes a stress buffering block 10A instead of the stress buffering block 10 shown in FIG. 1. Among constituent elements shown in FIG. 3, elements identical to those shown in FIG. 1 are denoted by like reference letters or numerals used in FIG. 1, and explanations thereof will be omitted.

The stress buffering block 10A has a two-layer laminated structure in which a first sub-block 10a₁ and a second sub-block 10a₂ are laminated in this order from the side of the heat sink 1. The first sub-block 10a₁ is made of a material having a coefficient of linear expansion smaller than that of the heat sink 1, for example, CuW-10, and has a size of 1.5 mm (length)x6.0 mm (width) as viewed from above, and has a thickness (height) of 0.4 millimeter. The second sub-block 10a₂ is made of a material having a coefficient of linear expansion smaller than that of the first sub-block 10a₁ and larger than that of the comb-shaped submount 20, or the same material as that of the comb-shaped submount 20, for example, aluminum nitride (AIN). The second sub-block 10a₂ has a size of 1.5 mm (length)x6.0 mm (width) as viewed from above, and has a thickness (height) of 0.4 millimeter. The first sub-block 10a₁ and the second sub-block 10a₂ are bonded to each other by a soldering material (not shown) such as alloy of gold and tin.

The optical module 50A having such a stress buffering block 10A can be manufactured in the same manner as that of the optical module 50 (see FIG. 1) described in the first embodiment, and has identical technical effects as those of the optical module 50. The coefficient of linear expansion of the stress buffering block 10A is lowered from the side of the heat sink 1 toward the comb-shaped submount 20 in a stepwise manner. Therefore, as compared with the optical module 50, it is easier to relax a thermal stress acting between the heat sink 1 and the comb-shaped submount 20, and thus it is easier to relax a thermal stress acting between the comb-shaped submount 20 and the device 30. As a result, as compared with the optical module 50, it is easier to enhance the long-term reliability of the bonding parts between the comb-shaped submount 20 and the device 30.

### Third embodiment.

In the optical module according to the present invention, when the laminated structure in which the plurality of sub-blocks are laminated is employed as the stress buffering block structure, the sub-blocks can be bonded to each other by a bonding material having a higher elastic modulus than that of an inorganic bonding material such as a soldering material, for example, an organic bonding material or an organic-inorganic combined bonding material in which metal or alloy particulates are dispersed in the organic bonding material. When the sub-blocks are bonded to each other by the organic bonding material or the organic-inorganic combined bonding material, the sub-blocks can be made of the same material or a different material having a coefficient of linear expansion equal to or smaller than that of the heat sink and equal to or larger than that of the comb-shaped submount, and the shape and size of the sub-blocks can be the same or different from each other.

When the sub-blocks are made of a material different from each other, to relax a thermal stress acting between the comb-shaped submount and the device, it is preferable to select the material of the sub-blocks such that a sub-block closer to the comb-shaped submount has a smaller coefficient of linear expansion, and a sub-block closer to the heat sink has a larger coefficient of linear expansion.

FIG. 4 is a schematic front view of another example of the optical module having a stress buffering block of a laminated structure. An optical module 50B shown in FIG. 4 has the same configuration as that of the optical module 50A shown in FIG. 3, except that the optical module 50B includes a stress buffering block 10B instead of the stress buffering block 10A shown in FIG. 3. Among constituent elements shown in FIG. 4, elements identical to those shown in FIG. 3 are denoted by like reference letters or numerals used in FIG. 3, and explanations thereof will be omitted.

The stress buffering block 10B has a two-layer laminated structure in which a first sub-block 10b₁ and a second sub-block 10b₂ are laminated in this order from the side of the heat sink 1. The first sub-block 10b₁ and the second sub-block 10b₂ are bonded to each other by a bonding material 11 having a higher elastic modulus than that of the inorganic bonding material such as a soldering material. The first sub-block 10b₁ and the second sub-block 10b₂ are made of a same kind of material such as CuW-10 having a coefficient of linear expansion equal to or smaller than that of the heat sink 1 and equal to or larger than that of the comb-shaped submount 20. The shape and size of the first and second sub-blocks are the same.

According to the optical module 50B having the stress buffering block 10B, the bonding material 11 is thermally deformed when a temperature difference is generated between the heat sink 1 and the comb-shaped submount 20, and the thermal stress is absorbed. Substantially, only a tensile stress is applied to the bonding material 11 and a bending stress is not substantially applied thereto. Therefore, peeling-off of the bonding parts between the comb-shaped submount 20 and the device 30 is suppressed. Therefore, the optical module 50B exhibits identical technical effects as those of the optical module 50 (see FIG. 1) described in the first embodiment, and it is easier for the optical module 50B to enhance the long-term reliability of the bonding parts between the comb-shaped submount 20 and the device 30 than the optical module 50.

### Fourth embodiment.

In the optical module according to the present invention, at least one groove can be provided in the stress buffering block. By providing the groove in the stress buffering block, the stress buffering block is easily thermally deformed, and thus its stress relaxing effect can be enhanced. Even when the stress buffering block is made thinner, identical stress relaxing effect can be obtained as compared with a case that no groove is provided. Therefore, it also becomes easy to make the optical module thinner. When the groove of the stress buffering block is located such that it is superposed on a groove formed on the comb-shaped submount as viewed from above, it also becomes easy to efficiently transmit heat generated by the device to the heat sink. The stress buffering block can be formed from one member, or can be of the laminated structure in which a plurality of sub-blocks are laminated.

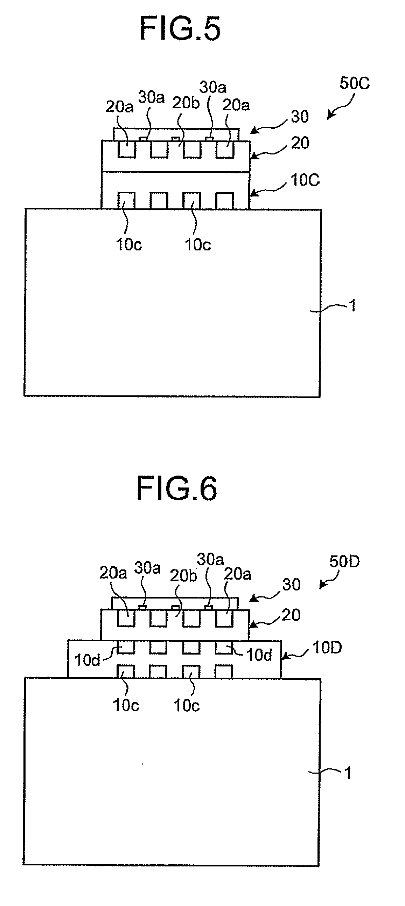

FIG. 5 is a schematic front view of an example of an optical module in which grooves are formed in a stress buffering block. An optical module 50C shown in FIG. 5 has the same configuration as that of the optical module 50 shown in FIG. 1, except that the optical module 50C includes a stress buffering block 10C instead of the stress buffering block 10 shown in FIG. 1. Among constituent elements shown in FIG. 5, elements identical to those shown in FIG. 1 are denoted by like reference letters or numerals used in FIG. 1, and explanations thereof will be omitted.

The stress buffering block 10C is made of a material having a coefficient of linear expansion smaller than that of the heat sink 1, for example, CuW-10, and has a size of 1.5 mm (length)x6.0 mm (width) as viewed from above, and has a thickness (height) of 0.8 millimeter. Four grooves 10c, 10c, ... in total are formed on one of surfaces of the stress buffering block 10C with the same pitch as that of grooves 20a, 20a, ... of the comb-shaped submount 20. The stress buffering block 10C is fixed on the heat sink 1 such that the grooves 10c are located on the side of the heat sink 1 and the grooves 10c are superposed on the grooves 20a of the comb-shaped submount 20 as viewed from above.

The optical module 50C having the stress buffering block 10C exhibits identical technical effects as those of the optical module 50 (see FIG. 1) described in the first embodiment. Because the grooves 10c are formed in the stress buffering block 10C, it is easier for the optical module 50C to relax a thermal stress acting between the comb-shaped submount 20 and the device 30 than the optical module 50, and it is also easier to enhance the long-term reliability of the bonding parts between the comb-shaped submount 20 and the device 30.

### Fifth embodiment.

FIG. 6 is a schematic front view of another example of the optical module in which the grooves are formed in the stress buffering block. An optical module 50D shown in FIG. 6 has the same configuration as that of the optical module 50C shown in FIG. 5, except that the optical module 50D includes a stress buffering block 10D instead of the stress buffering block 10C shown in FIG. 5. Among constituent elements shown in FIG. 6, elements identical to those shown in FIG. 5 are denoted by like reference letters or numerals used in FIG. 5, and explanations thereof will be omitted.

The stress buffering block 10D has four grooves 10d, 10d, ... in total formed on an upper surface thereof with the same pitch as that of the grooves 20a, 20a, ... of the comb-shaped submount 20. The stress buffering block 10D has a size of 1.5 mm (length)x6.0 mm (width) as viewed from above, and has a thickness (height) of 0.8 millimeter. The stress buffering block 10D is fixed on the heat sink 1 such that the grooves 10c and 10d are superposed on the grooves 20a of the comb-shaped submount 20 as viewed from above.

The optical module 50D having the stress buffering block 10D exhibits identical technical effects as those of the optical module 50C (see FIG. 5) described in the fourth embodiment. Because the grooves 10c and 10d are formed in the stress buffering block 10D, it is easier for the optical module 50D to relax a thermal stress acting between the comb-shaped submount 20 and the device 30 than the optical module 50C, and it is also easier to enhance the long-term reliability of the bonding parts between the comb-shaped submount 20 and the device 30.

### Sixth embodiment.

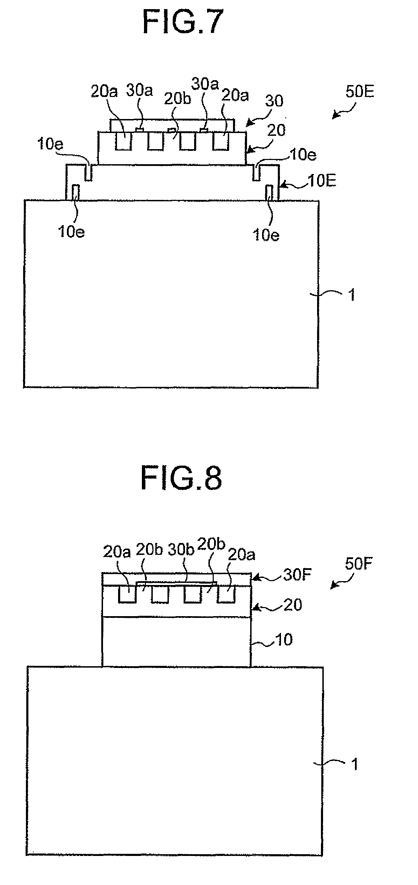

FIG. 7 is a schematic front view of another example of the optical module in which the grooves are formed in the stress buffering block. An optical module 50E shown in FIG. 7 has the same configuration as that of the optical module 50 shown in FIG. 1, except that the optical module 50E includes a stress buffering block 10E instead of the stress buffering block 10 shown in FIG. 1. Among constituent elements shown in FIG. 7, elements identical to those shown in FIG. 1 are denoted by like reference letters or numerals used in FIG. 1, and explanations thereof will be omitted.

According to the stress buffering block 10E, two grooves 10e and 10e are formed in the stress buffering block 10 on each of the side of the upper surface and the side of the lower surface, respectively, and the grooves 10e are in parallel to the grooves 20a formed in the comb-shaped submount. The grooves 10e on the side of the upper surface are located outside of the comb-shaped submount 20 to sandwich the comb-shaped submount 20 as viewed from above, and the grooves 10e on the side of the lower surface are located outside of the grooves 10e on the side of the upper surface to sandwich the grooves 10e on the side of the upper surface as viewed from above.

The optical module 50E having the stress buffering block 10E exhibits identical technical effects as those of the optical module 50 (see FIG. 1) described in the first embodiment. Because the grooves 10e are formed in the stress buffering block 10E, it is easier for the optical module 50E to relax a thermal stress acting between the comb-shaped submount 20 and the device 30 than the optical module 50, and it is also easier to enhance the long-term reliability of the bonding parts between the comb-shaped submount 20 and the device 30.

### Seventh embodiment.

In the optical module according to the present invention, a device other than the semiconductor laser array described in the first embodiment can be used as a device to be mounted on the comb-shaped submount. For example, it is possible to mount, on a comb-shaped submount, a light-emitting device having at least one waveguide-type laser oscillating unit as an optical functioning unit, or a light-receiving device having at least one optical waveguide or a waveguide-type photodiode as an optical functioning unit.

FIG. 8 is a schematic front view of an example of an optical module in which a light-emitting device having a waveguide-type laser oscillating unit is mounted on a comb-shaped submount. An optical module 50F shown in FIG. 8 has the same configuration as that of the optical module 50 shown in FIG. 1, except that the optical module 50F includes a device 30F instead of the device 30 shown in FIG. 1. Among constituent elements shown in FIG. 8, elements identical to those shown in FIG. 1 are denoted by like reference letters or numerals used in FIG. 1, and explanations thereof will be omitted.

The device 30F described above is a light-emitting device having a waveguide-type laser oscillating unit 30b, and functions as one constituent element of a solid-state laser device. By mounting the device 30F on the comb-shaped submount 20, the device 30F can generate a desired heat distribution, and it is possible suppress light diffusion in the waveguide-type laser oscillating unit 30b by a lens effect of the heat distribution. The optical module 50F having the device 30F exhibits identical technical effects as those of the optical module 50 (see FIG. 1) described in the first embodiment.

While the optical module according to the present invention has been explained above by exemplary embodiments, as mentioned above, the present invention is not limited to these embodiments. As for the optical module according to the present invention, various changes, modifications, and combinations other than those described above can be made.

### INDUSTRIAL APPLICABILITY

The optical module according to the present invention can be used as a display apparatus such as a laser television, a printing apparatus such as a laser printer, and a module constituting a light source of an apparatus such as an optical communications apparatus.

## Claims

1. An optical module (50) in which a comb-shaped submount (20) is fixed on a heat sink (1), and a device having an optical functioning unit (30) is mounted on the comb-shaped submount, wherein
a stress buffering block (10) that relaxes a thermal stress acting between the heat sink (1) and the comb-shaped submount (20) is placed between the heat sink (1) and the comb-shaped submount (20).

2. The optical module according to claim 1, wherein the stress buffering block (10) is formed by one member, and a coefficient of linear expansion of the stress buffering block (10) is smaller than that of the heat sink (1) and larger than that of the comb-shaped submount (20).

3. The optical module according to claim 1, wherein the stress buffering block (10A) has a laminated structure in which a plurality of sub-blocks (10a1, 10a2) are laminated.

4. The optical module according to claim 3, wherein a coefficient of linear expansion of the stress buffering block (10) is smaller than that of the heat sink (1) and larger than that of the comb-shaped submount (20).

5. The optical module according to claim 4, wherein a coefficient of linear expansion of each of the sub-blocks (10a1, 10a2) is set such that one located closer to the comb-shaped submount (20) has a smaller coefficient of linear expansion and one located closer to the heat sink has a larger coefficient of linear expansion.

6. The optical module according to claim 3, wherein the sub-blocks (10a1, 10a2) are bonded to each other by a bonding material having higher elastic modulus than that of a soldering material.

7. The optical module according to claim 6, wherein the sub-blocks (10a1, 10a2) are made of a same material.

8. The optical module according to claim 6, wherein the sub-blocks (10a1, 10a2) have same shape and size.

9. The optical module according to claim 1, wherein the stress buffering block (10C) has at least one groove (10c) on a side where the stress buffering block (10C) is bonded to the heat sink (1).

10. The optical module according to claim 1, wherein the stress buffering block (10D) has at least one groove (10d) on a side where the stress buffering block (10D) is bonded to the comb-shaped submount (20).

11. The optical module according to claim 1, wherein the device (30) includes a plurality of optical functioning units and each of the optical functioning units is a laser oscillator.

12. The optical module according to claim 1, wherein the optical functioning unit of the device (30) is a waveguide-type laser oscillating unit (30b) for a solid-state laser.
